Europäisches Patentamt

European Patent Office

Office européen des brevets

(19)

(11) Veröffentlichungsnummer: **0 005 181**
**B1**

(12) **EUROPÄISCHE PATENTSCHRIFT**

(45) Veröffentlichungstag der Patentschrift: **21.10.81**

(51) Int. Cl.³: **H 01 L 29/78**

(21) Anmeldenummer: **79101040.8**

(22) Anmeldetag: **05.04.79**

(54) **Verfahren zur Herstellung einer, Bauelemente vom Feldeffekttransistortyp enthaltenden, Halbleiteranordnung.**

(30) Priorität: **05.05.78 US 904182**

(43) Veröffentlichungstag der Anmeldung:
**14.11.79 Patentblatt 79/23**

(45) Bekanntmachung des Hinweises auf die Patenterteilung:
**21.10.81 Patentblatt 81/42**

(84) Benannte Vertragsstaaten:
**DE FR GB**

(56) Entgegenhaltungen:
**DE - A - 2 400 670**

**IBM TECHNICAL DISCLOSURE BULLETIN
Vol. 18, Nr. 9, Februar 1976,
New York, USA,
J. S. LOGAN et al.: "Submicron FET process
step sequence to provide multilayer metal
structure", Seiten 3105—3107.**

(73) Patentinhaber: **International Business Machines
Corporation
Armonk, N.Y. 10504 (US)**

(72) Erfinder: **Joshi, Madhukar Laxman
9 Walden Woods
Essex Junction Vermont 050452 (US)**
Erfinder: **Mason, Richard Karl
22 Pine Meadow Drive
Winooski Vermont 05404 (US)**
Erfinder: **Pricer, Wilbur David
58 Van Patten Parkway
Burlington Vermont 05401 (US)**

(74) Vertreter: **Oechssler, Dietrich Dr. rer. nat.
Schönaicher Strasse 220
D-7030 Böblingen (DE)**

## Verfahren zur Herstellung einer Bauelemente vom Feldeffekttransistortyp enthaltenden Halbleiteranordnung

Halbleiteranordnungen mit Baulementen vom Feldeffekttransistortyp lassen sich bekanntermaßen mit einem sehr geringen Aufwand an Halbeiterfläche pro Bauelement, z. B. pro Feldeffekttransistorstruktur, realisieren. Der vollen Ausnützung einer prozeßtechnisch vielfach möglichen Miniaturisierung sind allerdings häufig dadurch Grenzen gesetzt, daß in Abhängigkeit von den im jeweiligen Verfahrensablauf vorgesehenen Maskenschritten Abstandszuschläge aufgrund der für eine einwandfreie Justierung zu berücksichtigenden Maskentoleranzen zwischen den einzelnen Maskierungsschritten vorgesehen werden müssen. Ein derartiger Herstellungsprozeß wird meistens weiterhin durch das Erfordernis metallischer oder allgemein elektrisch leitfähiger Kontakte und Leitungs- sowie Kreuzungsverbindungen und der dafür erforderlichen Flächenanteile nachteilig beeinflußt. Aus all diesen Gründen ist man deshalb bestrebt, Herstellungsverfahren verfügbar zu haben, die sog. Selbstjustierungseigenschaften haben, möglichst mit einem Minimum an Maskenschritten auskommen und zudem, ohne in zusätzlichen Prozeßschritten weitere Isolierlagen erst schaffen zu müssen, Kreuzungsmöglichkeiten hinsichtlich der elektrischen Verbindungen bieten.

Aus der Veröffentlichung "Three-Mask Self-Aligned MOS Technology" von C. C. Mai et al, in IEEE Transactions on Electron Devices, Dezember 1973, Seiten 1162 bis 1164 ist bereits ein mit lediglich drei Maskenschritten auskommender Herstellungsprozeß für Feldeffekttransistoren bekannt. Der dort mit einem Aluminium-Gate gebildete Transistor weist jedoch bezüglich seiner Kontakte keine Selbstjustierungseigenschaften auf und läßt insbesondere einen zum Gate-Bereich benachbarten Teil der Halbleiteroberfläche frei liegen, so daß dort die Gefahr einer möglichen Beeinflußung durch Verunreinigungen vorliegt. Auch die in der US—Patentschrift 3 958 323 mittels dreier Maskenschritte herstellbare Transistorstruktur weist keine selbstjustierten Kontakte auf. Ebenfalls kann dort nicht ohne zusätzliche Prozeßschritte eine Kreuzungsmöglichkeit, z. B. durch eine Verlängerung der Gate-Elektroden vorgenommen werden, da Dotierungsgebiete im Substrat nach Ausbildung der Gate-Elektrode erzeugt werden müssen, Soweit schließlich in der US—Patentschrift 3 699 646 die Herstellung von Feldeffekttransistoren und insbesondere von elektrischen Verbindungen zwischen der Gate-Elektrode eines ersten Elementes und einer gesteuerten Elektrode eines anderen Elementes behandelt ist, sind auch dort keine Kreuzungen möglich, ohne zusätzliche Verfahrensschritte vorzusehen. Zum Stand der Technik hinsichtlich Feldeffekttransistoren mit einer Gate-Elektrode aus polykristallinem Silicium sei in diesem Zusammenhang auf Solid-State Electronics, Pergamon Press, 1970, Vol. 13, Seiten 1125 bis 1144 verwiesen. Soweit schließlich im Rahmen der Herstellung derartiger Transistoren Metallsilicide für elektrisch leitende Verbindungsbereiche eingesetzt werden können, wird z. B. die US—Patentschrift 3 777 364 gennant. Aus der DE—A—2 400 670 ist ein Verfahren zur Herstellung von Feldeffekttransistoren bekannt, bei dem das Halbleiter substrat im Abstandsbereich zwischen der Gate-Elektrode und einer über dem Feldoxid verlaufenden elektrischen Verbindung einer den zweiten Leitungstyp bewirkenden und eine gesteuerte Bauelementzone ausbildenden Dotierungs behandlung unterzogen wird.

Die Erfindung, wie sie in den Patentansprüchen gekennzeichnet ist, löst die Aufgabe, ein Verfahren zue Herstellung derartiger Halbleiteranordnungen bereitzustellen, das bei einfachen Anforderungen hinsichtlich der erforderlichen Maskenschritte unter Ausnutzung weitgehend, selbstjustiert hergestellter Bauelementzonen und -anschlüsse hochdichte integrierte Schaltungen aufzubauen gestattet, wobei ohne zusätzliche Prozeßschritte Kreuzungsmöglichkeiten im Bereich der elektrisch leitenden Verbindungsebenen möglich sein sollen.

Zusammengefaßt wird nach der Erfindung zur Herstellung einer Bauelemente vom Feldeffekttransistortyp enthaltenden Halbleiteranordnung in einem mit insgesamt drei Maskenschritten auskommenden Verfahren ausgegangen von der Bildung streifenförmiger und voneinander beabstandeter Dotierungsgebiete im Halbleitersubstrat, die später, z. B. im Falle von Feldeffekttransistorstrukturen, als Source- oder Drain-Zuleitungen dienen. An dem einen Ende wird zwischen den Dotierungsgebieten eine erste schützende Beschichtung für die Ausbildung einer Gate-Elektrode und im Bereich des jeweils anderen Endes auf dem jeweiligen Dotierungsgebiet eine weitere schützende Beschichtung zur Ausbildung eines Anschlußkontakts aufgebracht. Gate-Elektrode und Anschlußkontakt(e) bestehen vorzugsweise aus polykristallinem Silicium. Schleißlich wird der verbliebene Abstandbereich zwischen der Gate-Elektrode mindestens einem der Dotierungsgebiete einer Ionenimplantation unterworfen. Dabei lassen sich in einem einfachen Herstellungsprozeß bezüglich der Gate-Elektrode sowie der Anschlußkontakte sog. selbstjustierte Bauelementstrukturen erzielen, wobei in vorteilhafter Weise Gate-Verbindungen die durch die Dotierungsgebiete dargestellten elektrischen Verbindungen kreuzen können, ohne daß für eine solche Ausbildung zusätzliche Prozeßschritte erforderlich wären.

Die Erfindung wird im folgenden anhand von Ausführungsbeispielen unter Zuhilfenahme der Zeichnungen näher erläutert.

Es zeigen:

Fig. 1 eine perspektivische Ansicht eines entsprechend der Erfindung hergestellten Transistors;

Fig. 2A eine Draufsicht auf ein Halbleitersubstrat nach Anwendung eines ersten Maskierungsschrittes;

Fig. 3A eine Querschnittsdarstellung entlang der mit 3—3 in Fig. 2A gezeigten Schnittlinie vor der Anwendung der ersten Maske;

Fign. 3B und 3C weitere Querschnittsdarstellungen entlang der in Fig. 2A mit 3—3 bezeichneten Schnittlinie zu zwei verschiedenen Verfahrensstufen während der Anwendung der ersten Maske;

Fig. 4A eine Querschnittsdarstellung entlang der in Fig. 2A mit 4—4 bezeichneten Schnittlinie während einer Verfahrensstufe, die weitgehend ähnlich zu dem in Fig. 3C illustrierten Fall ist;

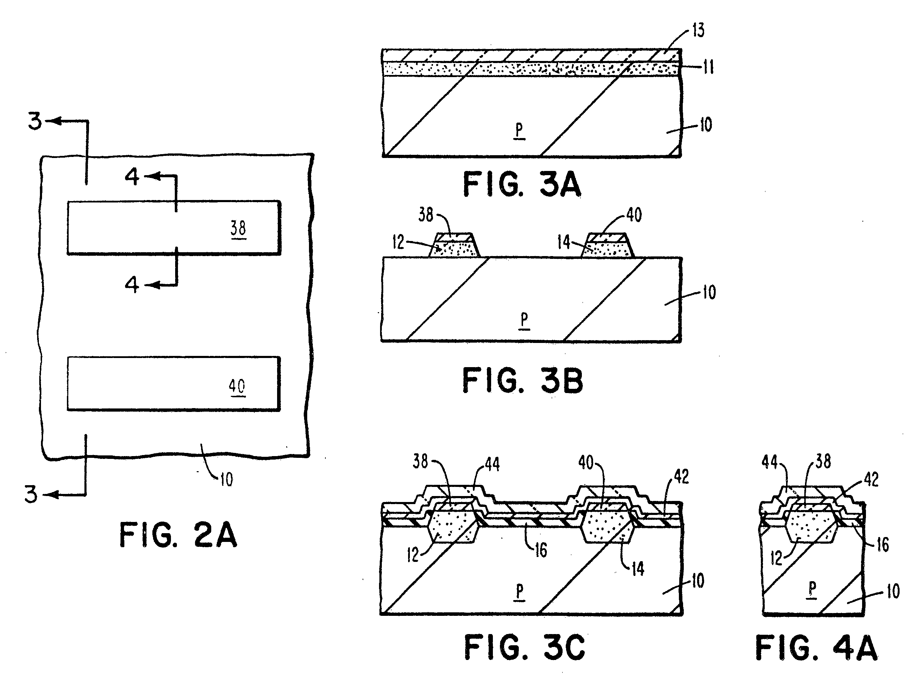

Fig. 2B eine Draufsicht ähnlich Fig. 2A, jedoch nach Anwendung eines zweiten Maskierungsschrittes;

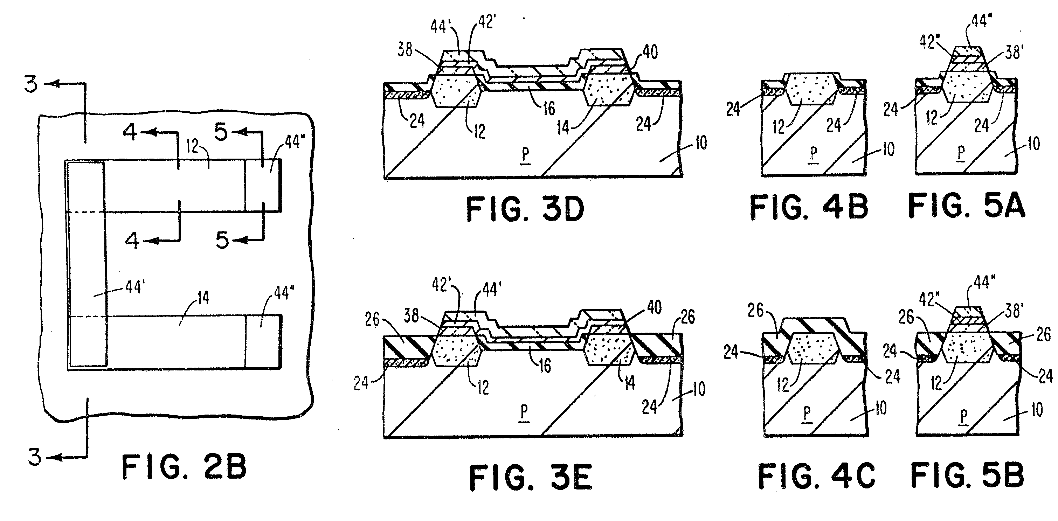

Fign. 3D und 3E Querschnittsdarstellungen entlang der in Fig. 2B mit 3—3 bezeichneten Schnittlinie während zweier verschiedener Verfahrenszeitpunkte beim Einsatz der zweiten Maske;

Fign. 4B und 4C Querschnittsdarstellungen entlang der in Fig. 2B mit 4—4 bezeichneten Schnittlinie entsprechend den in den Fign. 3D bzw. 3E illustrierten Verfahrensstufen;

Fign. 5A und 5B Querschnittsdarstellungen entlang der in Fig. 2B mit 5—5 bezeichneten Schnittlinie, ebenfalls entsprechend zu den in den Fign. 3D bzw. 3E illustrierten Verfahrensstufen;

Fig. 2C eine Draufsicht entsprechend Fig. 2B, jedoch nach Anwendung des dritten Maskierungsschrittes;

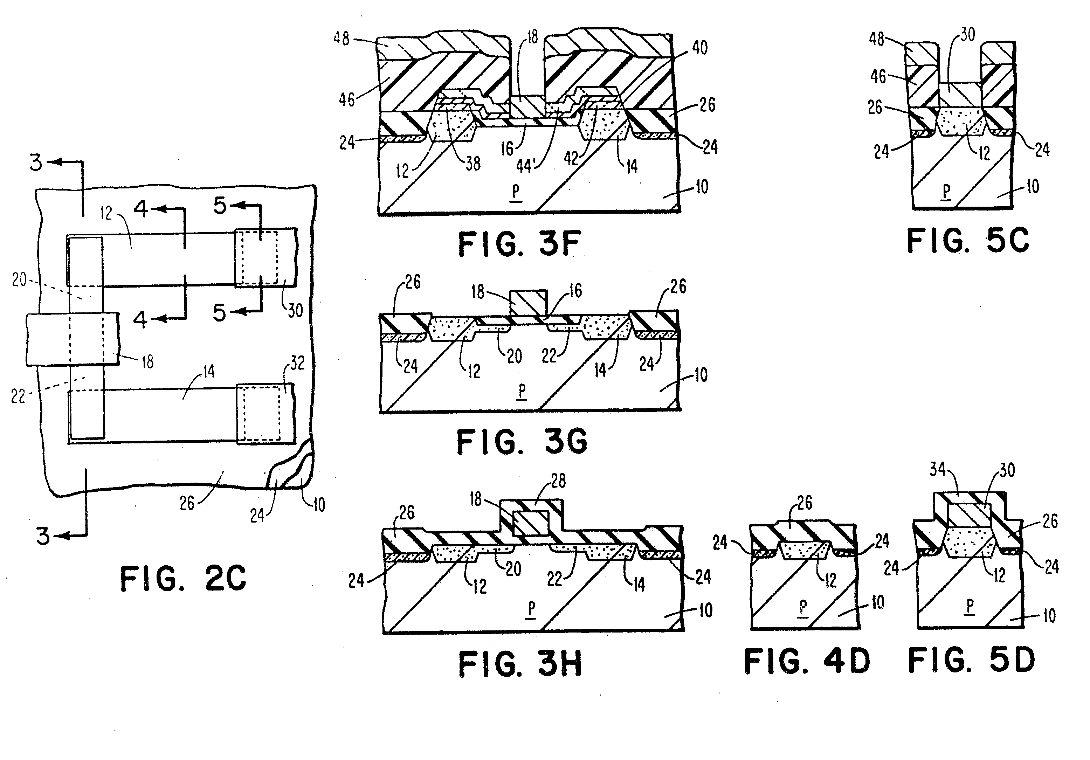

Fign. 3F, 3G, 3H Querschnittsdarstellungen entlang der in Fig. 2C mit 3—3 bezeichneten Schnittlinie zu drei verschiedenen Verfahrensstufen im Rahmen der Anwendung des dritten Maskierungsschrittes;

Fig. 4D eine Querschnittsdarstellung entlang der in Fig. 3C mit 4—4 bezeichneten Schnittlinie während der Fig. 3H entsprechenden Verfahrensstufe und

Fign. 5C und 5D Querschnittsdarstellungen entlang der in Fig. 2C mit 5—5 bezeichneten Schnittlinie während zweier zu den Darstellungen in den Fign. 3F und 3H ähnlicher Verfahrensstufen.

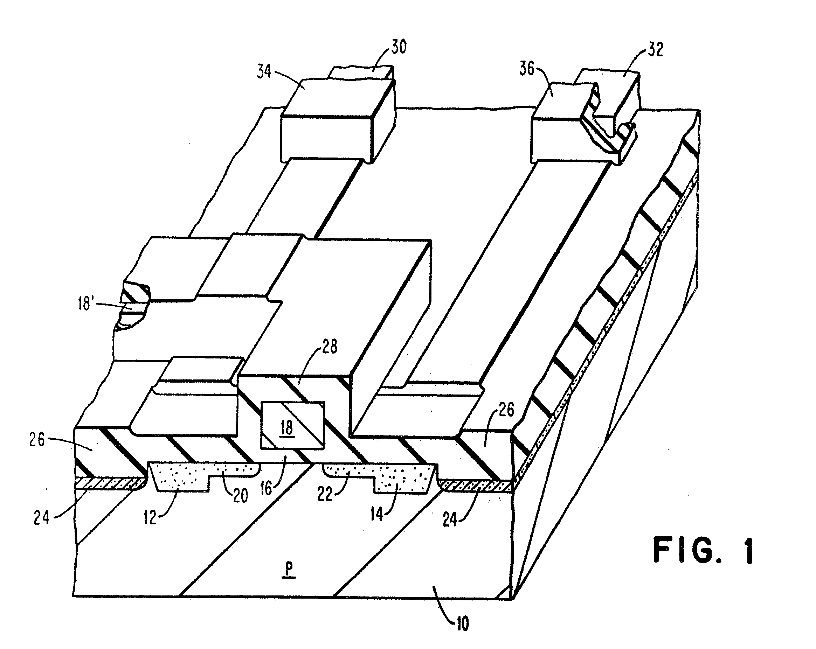

Im folgenden soll näher auf Fig. 1 eingegangen werden, in der in einer perspektivischen Ansicht eine Transistorstruktur dargestellt ist, die mittels des der Erfindung zugrundeliegenden Verfahrens unter Einsatz von drei Masken aufgebaut werden kann. An der Oberfläche eines Halbleitersubstrats 10, das vorzugsweise aus P-leitendem Silicium besteht, sind langgestreckte erste und zweite Diffusionsgebiete 12 und 14 vom N+-Leitungstyp im wesentlichen parallel zueinander angeordnet. Über dem Substrat 10 defindet sich zwischen der Oberfläche des Substrats 10 und einer Gate-Elektrode 18, die vorzugsweise aus dotiertem polykristallinen Silicium (auch Polysilicium genannt) besteht, eine dünne Schicht 16 aus Siliciumdioxid. Im Gebiet zwischen den Diffusionsgebieten 12 und 14 und der Gate-Elektrode 18 sind Source- und Drainzonen 20 und 22 gebildet. Mit 24 ist ein sog. Kanalstopper bezeichnet, der aus P-leitendem Material besteht und an der Oberfläche des Substrats 10 außerhalb des Bereichs für Gate, Source und Drain angeordnet ist. Außerhalb der von der die erste Isolierschicht bildenden dünnen Schicht 16 aus Siliciumdioxid bedeckten Bereiche des Substrats 10 findet sich eine die weitere Isolierschicht bildende dicke Oxid- bzw. Isolierschicht 26. Eine vorzugsweise aus einem Oxid des Polysiliciums 18 bestehende Isolierschicht 28 dient zur Isolierung der Polysiliciumschicht 18 und deren mit 18' bezeichneten Verlängerung, die quer über das Diffusionsgebiet 12 verläuft und davon durch die dicke Oxidschicht 26 getrennt ist. Die Diffusionsgebiete 12 und 14 erstrecken sich unter der dicken Oxidschicht 26 zu den mit 30 bzw. 32 bezeichneten Anschlüssen, deren zugehörige Isolierschicht mit 34 bzw. 36 bezeichnet sind. Die Anschlüsse 30 und 32 bestehen ebenfalls vorzugsweise aus Polysilicium, wobei die Isolierschichten 34 und 36 vorzugsweise aus einem Oxid des Polysiliciums bestehen.

Zur Herstellung der in Fig. 1 illustrierten Feldeffekttransistorstruktur werden in die Oberfläche des mit 10 bezeichneten Halbleitersubstrats N+-Ionen in an sich bekannter Weise flach mit einer hohen Konzentration implantiert, um eine in Fig. 3A mit 11 bezeichnete Diffusionsschicht zu bilden. Über der Diffusionsschicht 11 erstreckt sich eine Schicht 13 aus Siliciumnitrid. Zum Erhalt der anhand von Fig. 3B veranschaulichten Struktur werden unter Anwendung einer ersten Maske und an sich bekannter Maskierungs- und Ätzverfahren mesaförmige Diffusionsgebiete 12 und 14 gebildet, auf denen sich Streifen 38 und 40 aus Siliciumnitrid erstrecken. Die Entfernung des Siliciumnitrids kann mittels warmer Phosphor- oder Flußsäure erfolgen; das dotierte Silicium läßt sich mittels wässriger Lösungen von Flußsäure und Salpetersäure entfernen. Mittels bekannter thermischer Oxidationsverfahren wird anschließend die dünne Schicht 16 aus Siliciumdioxid auf der Oberfläche des Substrats 10 gebildet. Eine erste dünne Lage (42 in Fig. 3C) aus polykristallinem Silicium wird dann über der Schicht 16 aus Siliciumdioxid bzw. über den streifenförmigen Siliciumnitridbereichen 38 und 40 aufgebracht, gefolgt von einer zweiten Schicht 44 aus Siliciumnitrid über der ersten Polysiliciumlage 42. Eine entsprechende Darstellung der insoweit resultierenden Struktur findet sich in den Figs. 3C und 4A, die entlang der in Fig. 2A mit 3—3 bzw. 4—4 bezeichneten Schnittlinie bestehen. Die Polysiliciumschicht 42 kann durch Zersetzung von Silan in Gegenwart eines Bor enthaltenden Gases bei einer Temperatur von etwa 900 °C niedergeschlagen werden. Festzuhalten ist, daß die Diffusionsgebiete 12 und 14 sich während der Bildung der Schichten 16, 42 und 44 in der in den Fign. 3C und 4A gezeigten Weise in das Substrat 10 hinein ausweiten. Nach der Anwendung der ersten Maske liegen somit die mit einem geringen spezifischen Widerstand ausgestatteten Diffusionsgebiete 12 und 14 mit dem Gate-Oxid 16 vor.

Unter Anwendung einer zweiten Maske wird zwischen den Diffusionsgebieten 12 und 14 ein Bereich 44' der zweiten Schicht 44 aus Siliciumnitrid wie auch ein Bereich 42' der ersten Polysiliciumschicht 42 in der in Fig. 3D gezeigten Weise abgegrenzt. Ferner wird in der in Fig. 5A gezeigten Weise in der Siliciumnitridschicht 44 ein Segment bzw. Teilbereich 44'' über einem Bereich 38' auf dem streifenförmigen Siliciumnitrid 38 abgegrenzt, zwischen dem sich ein mit 42'' bezeichneter Teilbereich der ersten Polysiliciumschicht 42 befindet. Als geeignetes Ätzmittel für die Polysiliciumschicht 42 kann Flußsäure und Salpetersäure in wässriger Lösung oder eine Mischung aus Flußsäure, Salpetersäure und Essigsäure benutzt werden. Wie in Fig. 4B angedeutet ist, wurde die Siliciumnitridschicht 44 zusammen mit der ersten Polysiliciumschicht 42 entfernt, so daß die Oberfläche des Diffusionsbereichs 12 freigelegt ist. Der mit 24 bezeichnete sog. Kanalstopper wird vorzugsweise durch Implantation von einen P-Leitungstyp verursachenden Ionen in die Oberfläche des Substrats 10 hergestellt, nachdem die mit 42' und 44' bezeichneten Bereiche ausgebildet worden sind. Fig. 3E zeigt einen Querschnitt, der mit dem von Fig. 3B weitgehend ähnlich ist, außer daß die mit 26 bezeichnete dicke Oxidschicht mittels bekannter thermischer Oxidationsverfahren erzeugt ist. Weiterhin ist ersichtlich, daß Fig. 4C ähnlich zu Fig. 4B und Fig. 5B ähnlich zu Fig. 5A ist, wobei lediglich im Unterschied dazu in den Fign. 4C und 5B die mit 26 bezeichnete dicke Oxidschicht vorhanden ist.

Nach Anwendung des zweiten Maskenschrittes sind somit durch die mit 38' und 44' bezeichneten Bereiche die Anschlußflächen festgelegt sowie die dicke Oxidschicht 26 gebildet.

Fig. 2C zeigt eine Draufsicht auf das Halbleitersubstrat 10, nachdem im Rahmen der vorliegenden Erfindung ein dritter Maskenschritt eingesetzt worden ist. Über die insoweit ausgebildete Halbleiterstruktur wurde eine bekannte Photolackschicht 46 aufgebracht, wobei unter Einsatz der dritten Maske ein Gate-Bereich zwischen den Diffusionsgebieten 12 und 14 definiert worden ist, indem man einen Teil der Photolackschicht 46, der Schicht 44' aus Siliciumnitrid sowie der ersten Polysiliciumschicht 42 in der in Fig. 3F gezeigten Weise durch Ätzen entfernt hat. Als Lösungsmittel für den Photolack kann in bekannter Weise Butylacetat oder N-Methylpyrrolidon verwendet werden. Die dritte Maske wird ebenfalls dazu benutzt, die Anschlußflächen auf den Diffusionsgebieten 12 und 14 freizulegen, nachdem die in Fig. 5A mit 38', 32'' und 44'' bezeichneten Bereiche weggeätzt sind. Über die Anordnung wird dann eine zweite Polysiliciumschicht 48 aufgebracht, in der mittels bekannter sog. Abzieh- bzw. Lift-off-Technik die Gate-Elektrode 18 in der in den Fign. 3F und 3G gezeigten Weise sowie die in den Fign. 2C und 5C mit 30 und 32 bezeichneten Anschlußelektroden über den Diffusionsgebieten 12 und 14 ausgebildet werden. Die Photolackschicht 46 wird dann mittels bekannter Techniken vollständig zusammen mit der die Photolackschicht 46 überdeckenden Polysiliciumschicht entfernt. Ebenfalls werden die übriggebliebenen Bereiche der Siliciumnitridschichten 44', 38 und 40 mittels an sich bekannter Eintauchätzung entfernt, wie das gleichermaßen für den übriggebliebenen Teil der ersten Polysiliciumlage 42' der Fall ist. Wie in Fig. 3G illustriert ist, wird anschließend mittels bekannter Ionenimplantationsbehandlung die Ausbildung der Source- und Drainzonen 20 und 22 im Substrat 10 zwischen der Gate-Elektrode 18 und den Dotierungsgebieten 12 und 14 vorgenommen.

Mittels einer thermischen Oxidationsbehandlung wird dann die mit 26 bezeichnete dicke Oxidschicht über den Dotierungsgebieten 12 und 14 sowie über den Source- und Drainzonen 20 und 22 und die Oxidschicht 28 über der Elektrode 18 in der in Fig. 3H gezeigten Weise gebildet. Die in Fig. 4D gezeigte Querschnittsdarstellung entlang der in Fig. 2C mit 4—4 bezeichneten Schnittlinie illustriert die dicke Oxidschicht 26 über dem Dotierungsgebiet 12. Fig. 5D zeigt in einem Querschnitt entlang der in Fig. 2C mit 5—5 bezeichneten Schnittlinie die Struktur der Anschlußelektrode 30 zusammen mit der zugehörigen Isolierschicht 34.

Es its somit festzustellen, daß mit dem beschriebenen mit drei Maskenschritten auskommenden Verfahrensgang nach der Erfindung eine Feldeffekttransistorstruktur herstellbar ist, die sowohl eine selbstjustierte Gate-Elektrode als auch selbstjustierte Anschlußelektroden sowie Überkreuzungsanordnungen bietet.

Soweit in dem hier beschriebenen Ausführungsbeispiel lediglich eine verbesserte Feldeffekttransistorstruktur beschrieben wurde, ist dennoch festzustellen, daß durch die Hinzufügung des einen oder anderen Behandlungsbzw. Maskierungsschrittes eine Vielzahl verschiedener Speicher- und Logikstrukturen herstellbar ist. Weiterhin ist festzuhalten, daß anstelle des in dem beschriebenen Ausführungsbeispiels benutzten Polysiliciums für die Gate- und Anschlußelektroden 18 bzw. 30 und 32 andere Materialien in Form an sich bekannter Metallsilicide oder hochtemperaturfester Metalle, wie z. B. Tantal mit anodisch gebildeten Tantaloxid als Isolationsschicht auf der Oberfläche des Tantals, eingesetzt werden können. Sofern mehrere Leitebenen erwünscht sind, können auch andere Materialien, die thermisch, chemisch oder anodisch in einem unmaskierten Durchlaufverfahren selbstisolierbar sind, benutzt werden.

Weiterhin soll darauf hingewiesen werden, daß die erste Polysiliciumschicht 42 nicht unbedingt nötig ist, wenn es nicht gilt, unerwünschte Verunreinigungen, die durch die Siliciumnitridschicht 44 in die dünne Siliciumschicht 16 eindringen könnten, auszuschließen. Schließlich kann statt der in Fig. 3A mit 11 bezeichneten ionenimplantierten Schicht auch die Bildung dieser Schicht mittels Diffusion aus einem dotierten Oxid oder durch offene oder geschlossene (Kapsel-) Diffusion erfolgen.

## Patentansprüche

1. Verfahren zur Herstellung einer Bauelemente vom Feldeffekttransistortyp enthaltenden Halbleiteranordnung gekennzeichnet durch die folgende Verfahrensausgestaltung:

a) unter Anwendung eines ersten Maskenschrittes werden in einem Halbleitersubstrat (10) vom ersten Leitungstyp jeweils voneinander beabstandet ein erstes und zweites streifenförmiges Dotierungsgebiet (12, 14) vom zweiten Leitungstyp ausgebildet (Fig. 2A);

b) auf der Halbleiteroberfläche wird im Bereich zwischen den beabstandeten Dotierungsgebieten (12, 14) mittels einer Oxidationsbehandlung eine erste Isolierschicht (16) aufgebracht;

c) unter Anwendung eines zweiten Maskenschrittes werden auf der Oberfläche der insoweit hergestellten Struktur durch eine weitere Beschichtung geschützte Bereiche (44', 44'' z.B. in Fig. 2B) abgegrenzt, von denen ein an einem in Längsrichtung der Dotierungsgebiete liegenden Ende angeordneter erster geschützter Bereich (44') als sich von der vom zweiten Dotierungsgebiet abgewandten Längskante des ersten Dotierungsgebietes (12) über die Isolierschicht (16) zwischen den Dotierungsgebieten (12, 14) bis zu der vom ersten Dotierungsgebiet abgewandten Längskante des zweiten Dotierungsgebietes (14) erstreckend ausgebildet wird und mindestens ein zweiter geschützter Bereich (44'') jeweils einen Kontaktbereich abgrenzend und eines der Dotierungsgebiete (12, 14) an ihrem jeweils anderen in Längsrichtung liegenden Ende bedeckend geformt wird;

d) auf den nach Abschluß des Verfahrensschrittes c) noch freiligenden Oberflächenbereichen, insbesondere der Dotierungsgebiete (12 und/oder 14) wird eine weitere Isolierschicht (26) erzeugt (Fign. 1, 4C);

e) unter Anwendung eines dritten Maskenschrittes wird zum einen in der den ersten geschützten Bereich (44') in Fig. 2B) bildenden Beschichtung zwischen den Dotierungsgebieten (12, 14) eine bis auf die erste Isolierschicht (16) hinunterreichende Öffnung für eine Gate-Elektrode (18, z.B. in Fign. 2C, 3F) sowie zum anderen in mindestens einem der zweiten geschützten Bereiche (44'' in Fig. 2B) eine bis auf das (die) Dotierungsgebiet(e) (12, 14) hinunterreichende Öffnung für eine Anschlußelektrode (30, 32, z.B. in Fign. 2C, 5C) hergestellt und anschließend die Ausbildung der jeweiligen Elektroden (18, 30, 32) vorgenommen;

f) das Halbleitersubstrat (10) wird im Abstandsbereich zwischen der Gate-Elektrode (18) und mindestens einem der Dotierungsgebiete (12, 14) einer den zweiten Leitungstyp bewirkenden und die gesteuerte(n) Bauelementzone(n) (20, 22) ausbildenden Dotierungsbehandlung unterzogen.

2. Verfahren nach Anspruch 1, dadurch gekennzeichnet daß im Verfahrensschritt a) wenigstens eines der Dotierungsgebiete (12, 14) aus einem im Halbleitersubstrat (10) durch Ionenimplantation gebildeten Dotierungsstreifen (11) durch eine selektive Ätzbehandlung hergestellt wird (Fign. 3A, 3B).

3. Verfahren nach Anspruch 1 oder 2, dadurch gekennzeichnet, daß in Anschluß an den Verfahrensschritt a) das (die) Dotierungsgebiet(e) (12, 14) mit einer ersten Schicht (38, 40) aus einem oxidationshemmenden Material, vorzugsweise aus Siliciumnitrid, auf der Oberfläche bedeckt wird (Fig. 3B), woran sich eine thermische Oxidationsbehandlung der freiliegenden Halbleiteroberfläche zur Herstellung der ersten Isolierschicht (16) anschließt.

4. Verfahren nach einem der Ansprüche 1 bis 3, dadurch gekennzeichnet, daß die Beschichtung des im Verfahrensschritt c) genannten ersten geschützten Bereichs (44', z.B. in Fig. 2B) eine Schichtenfolge Oxid/Poly-Si/Nitrid (16/42'/44', z.B. in Fig. 3D) und die der zweiten geschützten Bereiche (44'') eine Schichtenfolge Nitrid/Poly-Si/Nitrid (z.B. 38'/42''/44'' in Fig. 5A) umfassen.

5. Verfahren nach einem der Ansprüche 1 bis 4, dadurch gekennzeichnet, daß im Verfahrensschritt c) die Abgrenzung der ersten und zweiten geschützten Bereiche (44', 44'') gleichzeitig durchgeführt wird.

6. Verfahren nach einem der Ansprüche 1 bis 5, dadurch gekennzeichnet, daß zur Ausbildung der Gate-Elektrode (18) im Verfahrensschritt e) ein sog. Lift-off-Verfahren angewendet wird (vgl. Fig. 3F).

7. Verfahren nach einem der Ansprüche 1 bis 6, dadurch gekennzeichnet, daß die Ausbildung der Gate-Elektrode (18) sowie der Anschlußelektrode(n) (30, 32) im Verfahrensschritt e) gleichzeitig und vorzugsweise aus einer polykristallinen Siliciumbeschichtung (48, z.B. in Fign. 3F, 5C) erfolgt.

8. Verfahren nach einem der Ansprüche 1 bis 7, dadurch gekennzeichnet, daß in der Ebene der Gate-Elektrode (18) elektrisch leitende, insbesondere Kreuzungen hinsichtlich der durch die Dotierungsgebiete (12, 14) dargestellten elektrischen Verbindungen bildende Schichtbereiche, z.B. für die Gate-Zuführungsleitung (18' in Fig. 1), aus polykristallinem Silicium mit einer Oberflächenoxidschicht (28) hergestellt werden.

9. Verfahren nach einem der Ansprüche 1 bis 8, dadurch gekennzeichnet, daß die Gate-Elektrode im Verfahrensschritt e) mit einer Überlappung des oxidierten ersten Dotierungsgebietes (12) ausgebildet wird.

10. Verfahren nach einem der Ansprüche 1 bis 9, dadurch gekennzeichnet, daß die im Verfahrensschritt f) genannte Ausbildung der gesteuerten Bauelementzonen (20, 22), z.B. für Source und Drain durch Anwendung einer Ionenimplantation erfolgt.

**Claims**

1. Method of making a semiconductor arrangement containing components of the field effect transistor type, characterized by the following process steps:

a) using a first mask step, to provide in a semiconductor substrate (10) of the first conductivity type (Fig. 2A) first and second, spaced apart from one another, elongate doped regions (12, 14) of the second conductivity type;

b) providing a first insulation layer (16) on the semiconductor surface between the spaced doped regions (12, 14) by means of an oxidation treatment;

c) using a second mask step to define regions (44', 44", e.g. in Fig. 2B) protected by a further coating on the surface of the thus provided structure, a first protected region (44') thereof being arranged at one end (in the longitudinal direction) of the doped regions and being designed to extend from the longitudinal edge of the first doped region (12) which faces away from the second doped region, via the insulation layer (16) between the doped regions (12, 14), to the longitudinal edge of the second doped region (14) facing away from the first doped region, and at least a second protected area (44") thereof being formed to define a contact region and to cover the other end (in the longitudinal direction) of one of the doped regions (12, 14);

d) providing another insulating layer (26) (Figs. 1, 4C) on the surface areas still uncovered after process step c), particularly on the doped regions (12 and/or 14);

e) using a third mask step to make an opening reaching down to the first insulation layer (16) for a gate electrode (18, e.g. in Figs. 2C, 3F) in the coating forming the first protected region (44' in Fig. 2B) between the doped regions (12, 14) and to make an opening for a contact electrode (30, 32 e.g. in Figs. 2C, 5C) in at least one of the second protected regions (44" in Fig. 2B), that opening reaching down to the doped region(s) (12, 14), and subsequently making the respective electrodes (18, 30, 32);

f) exposing the semiconductor substrate (10) in the spacing region between the gate electrode (18) and at least one of the doped regions (12, 14) to a doping process producing the second conductivity type and forming the controlled component zone(s) (20, 22).

2. Method as claimed in claim 1, characterized in that in process step a) at least one of the doped regions (12, 14) is made, through a selective etching process (Figs. 3A, 3B), out of a doped strip (11) formed in the semiconductor substrate (10) by means of ion implantation.

3. Method as claimed in claim 1 or 2, characterized in that following the process step a) the doped region(s) (12, 14) is (are) covered on the surface with a first layer (38, 40) of an oxidation-decelerating material, preferably of silicon nitride, followed by a thermal oxidation processing of the exposed semiconductor surface for making the first insulation layer (16).

4. Method as claimed in any one of claims 1 to 3, characterized in that the coating of the first protected region (44', e.g. in Fig. 2B) mentioned in process step c) comprises an oxide/poly-Si/nitride lamination (16/44'/44', e.g. in Fig. 3D), and the coating of the second protected regions (44") a nitride/poly-Si/nitride lamination (e.g. 38'/42"/44" in Fig. 5A).

5. Method as claimed in any one of claims 1 to 4, characterized in that process step c) defines the first and second protected regions (44', 44") simultaneously.

6. Method as claimed in any one of claims 1 to 5, characterized in that process step e) uses a so called lift-off process (see Fig. 3F) for making the gate electrode (18).

7. Method as claimed in any one of claims 1 to 6, characterized in that the gate electrode (18) as well as the contact electrode(s) (30, 32) are made simultaneously in process e), and preferably of a polycrystalline silicon coating (48, e.g. in Figs. 3F, 5C).

8. Method as claimed in any one of claims 1 to 7, characterized in that electrically conductive layers, in particular cross-overs with regard to the electrical connections represented by the doped regions (12, 14), are made in the plane of the gate electrode (18), e.g. for the gate supply line (18' in Fig. 1), said layers consisting of polycrystalline silicon with a surface oxide layer (28).

9. Method as claimed in any one of claims 1 to 8, characterized in that the gate electrode is made in process step e) so that it overlaps the oxidized first doped region (12).

10. Method as claimed in any one of claims 1 to 9, characterized in that the controlled component zones (20, 22) mentioned in process step f), e.g. for source and drain, are made by means of an ion implantation.

## Revendications

1. Procédé pour fabriquer un arrangement semi-conducteur comportant des composants du type transistors à effet de champ caractérisé par les étapes de procédé suivantes:

a) dans une première étape de masquage, on produit dans un substrat semi-conducteur (10) due premier type de conductivité, des première et seconde régions de dopage sous forme de bande (12, 14) du second type de conductivité, espacée l'une de l'autre (figure 2A);

b) sur la surface semi-conductrice on élabore, une première couche d'isolement (16) disposée entre les régions de dopage (12, 14) espacées les unes des autres, au moyen d'un traitement d'oxydation;

c) dans une seconde étape de masquage, on délimite sur la surface de la structure ainsi obtenue, des régions (44', 44''', par exemple sur la figure 2B) qui seront ultérieurement protégées: une première région protégée (44'), disposée à une extrémité située dans la direction longitudinale, desdites régions de dopage, et disposée de sorte à s'étendre à partir du bord longitudinal de la première région de dopage (12) vers la seconde région de dopage, le long de la couche d'isolement (16) entre les régions de dopage (12, 14), jusqu'au bord longitudinal de la seconde région de dopage (14), et au moins une seconde région protégée (44'') qui est formée pour délimiter une région de contact et couvrir une des régions de dopage (12, 14) à son autre extrémité selon le sens longitudinal;

d) sur les régions de surface non encore exposées après l'étape de procédé c), en particulier les régions de dopage (12 et/ou 14) on forme une couche d'isolement (26) supplémentaire (figures 1, 4C);

e) dans une troisième étape de masquage, on produit d'une part dans la couche formant la première région protégée (44' de la figure 2B) entre les régions de dopage (12, 14), une ouverture pénétrant jusqu'à la première couche d'isolement (16) pour la porte (18, par exemple sur les figures 2C, 3F), et d'autre part, dans au moins une des seconde régions protégées (44'' de la figure 2B), une ouverture pénétrant jusqu'à la région ou les régions de dopage (12, 14) (30, 32, par exemple sur les figures 2C, 5C) et on produit ensuite les électrodes respectives (18, 30, 32);

f) dans la région disposée entre la porte (18) et au moins une des régions de dopage (12, 14) le substrat semi-conducteur (10) est soumis à un traitement de dopage provoquant le second type de conductivité et formant la ou les zones de composant commandées (20, 22).

2. Procédé selon la revendication 1, caractérisé en ce que dans l'étape de procédé a) on produit à l'aide d'un traitement de décapage sélectif, au moins une des régions de dopage (12, 14), à partir d'une bande de dopage formée dans le substrat semi-conducteur (10) par implantation ionique (figures 3A, 3B).

3. Procédé selon la revendication 1 ou 2, caractérisé en ce qu'après l'étape de procédé a) la ou les régions de dopage (12, 14) sont recouvertes sur leur surface d'une première couche (38, 40) d'un matériau barrière pour l'oxydation, de préférence du nitrure de silicium (figure 3B), cette étape étant suivie par un traitement thermique d'oxydation de la surface semi-conductrice exposée pour produire la première couche d'isolement (16).

4. Procédé selon l'une quelconque des revendications 1 à 3, caractérisé en ce que le revêtement de la première couche protégée (44', par exemple sur la figure 2B) mentionné dans l'étape de procédé c) comporte la séquence oxyde/poly-Si/nitrure (16/42'/44', par exemple sur la figure 3D), et le revêtement des secondes régions protégées (44'') la séquence nitrure/poly-Si/nitrure (par exemple 38'/42''/44'' de la figure 5A).

5. Procédé selon l'une quelconque des revendications 1 à 4, caractérisé en ce que dans l'étape de procédé c) les première et seconde régions protégées (44', 44'') sont délimitées simultanément.

6. Procédé selon l'une quelconque des revendications 1 à 5, caractérisé en ce que l'on utilise pour former la porte (18) dans l'étape de procédé e) un procédé dit de décollement (voir la figure 3F).

7. Procédé selon l'une quelconque des revendications 1 à 6, caractérisé en ce que l'on forme la porte (18) ainsi que l'électrode ou les électrodes de connexion (30, 32) dans l'étape de procédé e) simultanément et de préférence à partir d'une couche de silicium polycristallin (48, par exemple sur les figures 3F, 5C).

8. Procédé selon l'une quelconque des revendications 1 à 7, caractérisé en ce que l'on produit dans le plan de la porte (18) des couches électriquement conductrices formant en particulier des points de croisement vis-à-vis des connexions électriques que sont les régions de dopage (12, 14); par exemple pour les lignes d'alimentation de porte (18' de la figure 1), cesdites couches étant composées de silicium polycristallin et d'une couche d'oxyde en surface (28).

9. Procédé selon l'une quelconque des revendications 1 à 8, caractérisé en ce que la porte dans l'étape de procédé e) est formée par chevauchement de la première région de dopage oxydée (12).

10. Procédé selon l'une quelconque des revendications 1 à 9, caractérisé en ce que les zones de composant commandées (20, 22) mentionnées dans l'étape de procédé f), par exemple pour la source et le drain, sont formées à l'aide d'une implantation ionique.

FIG. 1

FIG. 2A

FIG. 3A

FIG. 3B

FIG. 3C

FIG. 4A

0005 181

FIG. 5A

FIG. 4B

FIG. 5B

FIG. 4C

FIG. 3D

FIG. 3E

FIG. 2B

FIG. 2C

FIG. 3F

FIG. 3G

FIG. 3H

FIG. 4D

FIG. 5C

FIG. 5D

0005181